# EUROPEAN PATENT SPECIFICATION

(11) **EP 0 675 603 B1**
(45) Date of publication and mention of the grant of the patent: **24.05.2000**
(21) Application number: 94309908.5
(22) Date of filing: 29.12.1994
(51) Int. Cl.: H03M 1/28, H03M 1/30, G01D 5/245

(54) **Absolute position encoding method and absolute position encoder**
Verfahren zur Detektierung eines Absolutpositionssignals und Absolutpositionsgeber
Procédé de détection d'un signal de position absolue et codeur absolu

(30) Priority: 29.03.1994 JP 5928194
(43) Date of publication of application: 04.10.1995
(73) Proprietor: TAMAGAWA SEIKI KABUSHIKI KAISHA, Iida-shi, Nagano-ken (JP)
(72) Inventor: Seki, Shigeo, c/o Tamagawa Seiki K.K., Iida-shi, Nagano-ken (JP)
(74) Representative: Suckling, Andrew Michael

(56) References cited:
- EP-A- 0 341 314
- US-A- 4 736 187
- ELECTRONICS LETTERS, vol. 25, no. 21, page 1436/1437 XP 000080091 ROSS J N ET AL 'INCREMENTAL DIGITAL POSITION ENCODER WITH ERROR DETECTION AND CORRECTION'

## Description

The present invention relates to an absolute position encoding method and an absolute position encoder, and more particularly, to a new improvement for obtaining an absolute position encoder in a structure almost similar to an incremental position encoder, and for enabling an AC servo motor to immediately start up through detecting the positions of magnetic poles in the AC servo motor at power ON.

Heretofore, commonly used absolute position encoders each use one-track type n-bit positional signals, detect said n-bit positional signals through disposing n light receiving elements corresponding to the n bits toward the track (toward the circumference), and output the n-bit positional signals as positional signals accompanying displacement of an input axis position of the encoder.

Electronics Letters, vol. 25, no. 21, page 1436/1437 XP 000080091 Ross J N et al "Incremental Digital Position Encoder with Error Detection and Correction" describes an arrangement having a n-bit pseudorandom binary sequence and an incremental code.

Since conventional encoders are composed as above described, there are the following issues. The required number of signal processing circuits corresponding to the n elements that correspond to said n bits is n circuits. Problems such as signal adjustment of each of the n circuits exist due to variations in frequency characteristics between the n circuits, and hence it is very difficult to produce absolute position encoders in high reliability.

The object of the present invention is to solve the above issues, and in particular, objects of the present invention are to obtain an absolute position encoding method and an absolute position encoder in a structure almost similar to an incremental encoder, and to enable an AC servo motor to immediately start up through detecting positions of magnetic poles in the AC servo motor when power is first turned on.

An absolute position encoding method using an n-bit positional signal provided along a first track of a code plate and using an incremental signal having transitions corresponding to the pitch of said n-bit signal and provided along a second track of said code plate, said absolute position encoding method comprising the steps of providing on said code plate a third track containing an m-bit signal where said m-bit signal is representative of the magnetic pole positions of the rotating member of an AC servo motor; reading said m-bit signal at the time of turning power ON and loading said read m-bit signal into a counting circuit; subsequently reading said n-bit signal from said code plate and loading said read n-bit signal into said counting circuit; and incrementing or decrementing said loaded n-bit signal in accordance with signals read from said incremental track to provide the encoded angular position of said rotating member of said servo motor.

In a refinement this method further comprises: using a latch circuit to read said n-bit signal at the instants when said incremental signal changes its value; and loading said read n-bit signal through a serial to parallel signal converter into said counting circuit.

In a further refinement the counting circuit is caused to count upwards in response to said incremental signals for a first direction of rotation of said servo motor, and to count downwards in response to said incremental signals for a second direction of rotation of said servo motor.

An absolute encoder for providing absolute position signal using an n-bit positional signal formed on one track of a code plate, an incremental signal having transitions corresponding to the pitch of said n-bit signal and formed on another track of said code plate, and an m-bit signal representative of the magnetic pole positions of a rotating member of an AC servo motor formed on another track of said code plate, said encoder comprising an UP/DOWN circuit having an input coupled to means for reading said incremental signal, a counting circuit having an input coupled to an output of said UP/DOWN circuit, a latch circuit having inputs coupled to means for reading said n-bit signal and said incremental signal, a serial to parallel signal converter having an input coupled to an output of said latch circuit, a pure binary signal converter and a data selector coupled between an output of said serial to parallel signal convener and input means for said counting circuit, and a load command circuit, interconnecting said pure binary signal converter and a source of power ON/OFF signal with said data selector and said counting circuit, for controlling loading of said m-bit signal into the counting circuit at the time of turning power ON.

In an absolute position encoding method and an absolute position encoder according to the present invention, at power ON, a m-bit positional signal that is a detection signal of magnetic poles in an AC servo motor provided on a code plate is read into the data selector, and this m-bit positional signal from the data selector is read into the counting circuit, that is, the first load is performed. Next, with this m-bit positional signal, the AC servo motor is minutely (360°/2ⁿ) rotated, a n-bit positional signal is scanned and detected with an incremental signal corresponding to these n bits, using a latch circuit, and the second load is performed setting this n-bit positional signal as an absolute value against said counting circuit.

After completion of the loading of the n-bit signal, the encoder makes the counting circuit count up or down with the incremental signal, and obtains an absolute position signal through adding the incremental signal to the absolute value composed of the n-bit positional signal stored in the counting circuit at the above described second load.

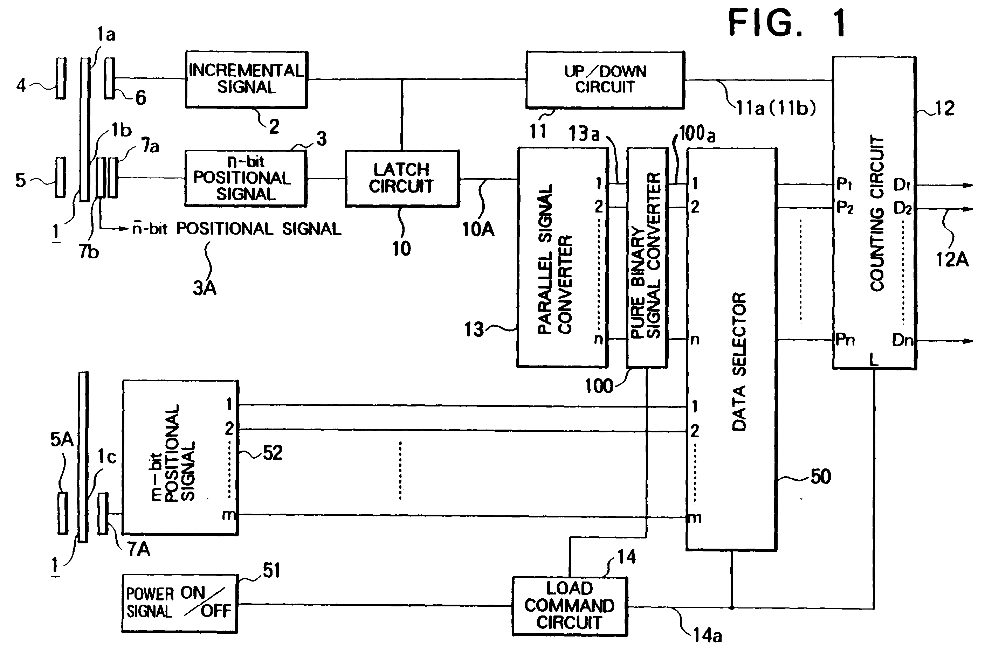

Figure 1 is a structural diagram showing an absolute position encoder according to the present invention.

Hereafter, preferred embodiments of an absolute position encoding method and an absolute encoder according to the present invention will be explained in detail with drawings.

A code plate is shown by reference numeral 1 in Figure 1, and the code plate 1 has a first track 1a with a code for a known incremental signal 2, a second track 1b with a code for a n-bit positional signal 3, and a third track 1c with a code corresponding to a m-bit positional signal 52 that is a detecting signal for the magnetic poles in an AC servo motor, and is provided in free rotation. Although in Figure 1, two code plates are provided, a common plate is used practically. On the left of this code plate 1 in Figure 1, a first light source 4, a second light source 5, and a third light source 5A corresponding to respective tracks 1a, 1b, and 1c are provided individually.

A light receiving section 6 for an incremental signal, a light receiving section 7 for an absolute position signal and a light receiving section 7A for a m-bit positional signal (composed of light receiving elements, the number of which corresponds to the m-bits) corresponding to said respective tracks 1a, 1b, and 1c are provided, and the light receiving section 7 for the absolute position signal is composed of a first light receiving section 7a to output a n-bit positional signal 3 and a second light receiving section 7b to output a n-bit positional signal 3A.

Said incremental signal 2 and n-bit positional signal 3 are inputted to the latch circuit 10, and the incremental signal 2 is also inputted to an UP/DOWN circuit 11 connected to a counting circuit 12. Said latch circuit 10 is connected to a parallel signal convener 13 for conversion of a serial signal to a parallel signal, which is connected to said counting circuit 12 through a data selector 50. The parallel signal convener 13 is connected to a data selector 50 through a pure binary signal convener 100, and a parallel signal 13a is inputted to the data selector 50 after being convened to a pure binary signal 100a. A load command circuit 14 connected to the pure binary signal convener 13, data selector 50, and counting circuit 12, is connected to a power ON/OFF signal 51 from a power switch (not shown), and load (storage) to the counting circuit 12 is started with a load command signal 14a from this load command circuit 14.

Next, operations will be described.

When the power switch (not shown) is turned on, the power ON signal 51 is inputted to the load command circuit 14, and a m-bit positional signal 52 (this is necessary to detect magnetic poles of the AC servo motor, and is used to drive the AC servo motor at power ON) obtained through the third track 1c for the m bits on said code plate 1 and a light receiving section for the m-bit positional signal is stored as the first load in the counting circuit 12 through the data selector 50. Subsequently, with this m-bit positional signal 52, the AC servo motor (not shown) is minutely (360°/2ⁿ) rotated, the n-bit positional signal 3 is scanned and detected with the incremental signal 2 corresponding to these n bits, using the latch circuit 10, and the second load is performed setting this m-bit positional signal 52 as an absolute value against said counting circuit 12.

After completion of said second load, the code plate 1 rotates with rotation of the AC servo motor, and this encoder makes the counting circuit 12 count up or down with the incremental signal 2 corresponding to said n-bit positional signal 3, can obtain an absolute signal 12A through adding the incremental signal 2 to the absolute value composed of the n-bit positional signal stored at the counting circuit in the above described second load, and can detect an input axis position of the AC servo motor.

Therefore, according to the present invention, in the structure that outputs the absolute signal 12A through having loaded the n-bit positional signal 3 to the counting circuit as an absolute value beforehand (for example, if the axis position 100/360° is scanned and loaded, the number, 100 becomes the absolute value) and adding the incremental signal 2 to this absolute value, in case the AC servo motor and absolute position encoder are connected, the initial starting can be performed with the m-bit positional signal 52 read from the third track 1c for the m bits having been recorded on the code plate 1 beforehand as a three-phase detecting signal (phases U, V, and W) of the magnetic poles for initially driving the AC servo motor. After this starting, because of adding the incremental signal 2 to the absolute value composed of the n-bit positional signal 3 having been loaded beforehand to the counting circuit 12, the input axis position of the AC servo motor can be obtained with the absolute signal 12A obtained from this absolute value and incremental signal 2.

Therefore, since the signal processing system for processing the n-bit positional signal 3 becomes one circuit, it becomes not necessary to use n channels of signal processing systems as conventional, at the same time, the m-bit positional signal as the detecting signal of the magnetic poles in the AC servo motor can be obtained, and detection of the magnetic poles and detection of the speed and position of the AC servo motor can be performed.

Since an absolute position signal detecting method and an absolute position encoder according to the present invention are composed as above described, following effects can be obtained.

Thus, even if the absolute signal is obtained after loading the n-bit positional signal, obtained from scanning the n-bit positional signal with the incremental signal, as the absolute value to the counting circuit, the AC servo motor can be immediately started up through regarding the m-bit positional signal obtained at power ON as the detecting signal of the magnetic poles. In addition, since the signal processing system for processing the n-bit positional signal 3 becomes one series from the conventional n-channels, drastic hardware reduction can be attained.

Furthermore, since the frequency characteristic of the incremental signal is better than that of the n-bit positional signal due to detection in larger received-light quantity with a plurality of slits, the absolute signal in good frequency characteristic can be obtained.

Still more, after completion of load to the counting circuit, the absolute value can be obtained from only the incremental signal on the basis of the absolute value having been loaded beforehand through having operated the counting circuit with the incremental signal.

In addition, in case of a motor-encoder combined an absolute encoder of the present invention with the AC servo motor, an absolute encoder for the AC servo motor can be obtained in the structure almost similar to an incremental encoder with the conventional detecting signal of the magnetic poles in the phases U, V and W.

## Claims

1. An absolute position encoding method using an n-bit positional signal provided along a first track (1b) of a code plate (1) and using an incremental signal (2) having transitions corresponding to the pitch of said n-bit positional signal (3) and provided along a second track of said code plate, said absolute position encoding method comprising the steps of providing on said code plate a third track containing an m-bit signal (52) where said m-bit signal is representative of the magnetic pole positions of the rotating member of an AC servo motor; reading said m-bit signal at the time of turning power ON and loading said read m-bit signal into a counting circuit; subsequently reading said n-bit positional signal from said code plate and loading said read n-bit positional signal into said counting circuit (12); and incrementing or decrementing said loaded n-bit positional signal in accordance with signals read from said incremental track to provide the encoded angular position of said rotating member of said servo motor.

2. An absolute position encoding method according to claim 1, further comprising the steps of using a latch circuit (10) to read said n-bit positional signal (3) at the instants when said incremental signal changes its value; and loading said read n-bit positional signal through a serial to parallel signal converter (13) into said counting circuit (12).

3. An absolute position encoding method according to claim 1 or claim 2, wherein said counting circuit (12) is caused to count upwards in response to said incremental signals for a first direction of rotation of said servo motor, and to count downwards in response to said incremental signals for a second direction of rotation of said servo motor.

4. An absolute position encoder for providing an absolute signal (12A) using an n-bit positional signal (3) formed on one track (1b) of a code plate (1), an incremental signal (2) having transitions corresponding to the pitch of said n-bit positional signal and formed on another track of said code plate, and an m-bit signal representative of the magnetic pole positions of a rotating member of an AC servo motor formed on another track of said code plate, said encoder comprising an UP/DOWN circuit (11) having an input coupled to means for reading said incremental signal (2), a counting circuit (12) having an input coupled to an output of said UP/DOWN circuit (11), a latch circuit (10) having inputs coupled to means for reading said n-bit positional signal (3) and said incremental signal (2), a serial to parallel signal converter having an input coupled to an output of said latch circuit, a pure binary signal convener (100) and a data selector (50) coupled between an output of said serial to parallel signal converter and input means for said counting circuit, and a load command circuit, interconnecting said pure binary signal converter and a source of power ON/OFF signal with said data selector and said counting circuit, for controlling loading of said m-bit signal (52) into the counting circuit (12) at the time of turning power ON.

## Patentansprüche

1. Absolutpositions-Codierverfahren, das von einem n-Bit-Positionssignal Gebrauch macht, das entlang einer ersten Spur (1b) einer Codeplatte (1) vorgesehen ist, und das von einem Inkrementsignal (2) Gebrauch macht, das Übergänge entsprechend der Teilung des n-Bit-Positionssignals (3) aufweist und entlang einer zweiten Spur der Codeplatte vorgesehen ist, wobei das Absolutpositions-Codierverfahren folgende Schritte aufweist:
- Vorsehen einer dritten Spur auf der Codeplatte, die ein m-Bit-Signal (52) enthält, wobei das m-Bit-Signal für die Magnetpolpositionen des Rotationselements eines Wechselstrom-Servomotors repräsentativ ist;
- Lesen des m-Bit-Signals zum Zeitpunkt des Einschaltens der Energieversorgung und Laden des gelesenen m-Bit-Signals in eine Zählschaltung;
- anschließendes Lesen des n-Bit-Positionssignals von der Codeplatte und Laden des gelesenen n-Bit-Positionssignals in die Zählschaltung (12); und
- Inkrementieren oder Dekrementieren des geladenen n-Bit-Positionssignals in Abhängigkeit von Signalen, die von der Inkrementspur ausgelesen werden, um die codierte winkelmäßige Position des Rotationselements des Servomotors zu bestimmen.

2. Absolutpositions-Codierverfahren nach Anspruch 1, mit folgenden weiteren Schritten:
Verwenden einer Zwischenspeicherschaltung (10) zum Lesen des n-Bit-Positionssignals (3) in denjenigen Momenten, in denen das Inkrementsignal seinen Wert ändert; und Laden des gelesenen n-Bit-Positionssignals durch einen Seriell-/Parallel-Signalwandler (13) in die Zählschaltung (12).

3. Absolutpositions-Codierverfahren nach Anspruch 1 oder Anspruch 2,
wobei die Zählschaltung (12) dazu veranlaßt wird, in Abhängigkeit von den Inkrementsignalen bei einer ersten Rotationsrichtung des Servomotors vorwärts zu zählen, sowie dazu veranlaßt wird, in Abhängigkeit von den Inkrementsignalen bei einer zweiten Rotationsrichtung des Servomotors rückwärts zu zählen.

4. Absolutpositions-Codierer zum Liefern eines Absolutsignals (12A) unter Verwendung eines n-Bit-Positionssignals (3), das auf einer Spur (1b) einer Codeplatte (1) ausgebildet ist, eines Inkrementsignals (2), das Übergänge entsprechend der Teilung des n-Bit-Positionssignals (3) aufweist und auf einer weiteren Spur der Codeplatte ausgebildet ist, sowie eines m-Bit-Signals, das die Magnetpolpositionen eines Rotationselements eines Wechselstrom-Servomotors repräsentiert und auf einer weiteren Spur der Codeplatte ausgebildet ist;
wobei der Codierer folgendes aufweist:
- eine Vorwärts-/Rückwärts-Schaltung (11), die einen mit einer Einrichtung zum Lesen des Inkrementsignals (2) gekoppelten Eingang aufweist,
- eine Zählschaltung (12), die einen mit einem Ausgang der Vorwärts-/Rückwärts-Schaltung (11) gekoppelten Eingang aufweist,
- eine Zwischenspeicherschaltung (10), die mit Einrichtungen zum Lesen des n-Bit-Positionssignals (3) und des Inkrementsignals (2) gekoppelte Eingänge aufweist,
- einen Seriell-/Parallel-Signalwandler, der einen mit einem Ausgang der Zwischenspeicherschaltung gekoppelten Eingang aufweist,
- einen reinen Binärsignalwandler (100) und eine Datenauswähleinrichtung (50), die zwischen einen Ausgang des Seriell-/Parallel-Signalwandlers und eine Eingangseinrichtung für die Zählschaltung geschaltet sind, sowie
- eine Ladebefehlsschaltung, die den reinen Binärsignalwandler und eine Quelle eines Energie-Einschalt-/Ausschaltsignals mit der Datenauswähleinrichtung und der Zählschaltung verbindet, um das Laden des m-Bit-Signals (52) in die Zählschaltung (12) zum Zeitpunkt des Einschaltens der Energieversorgung zu steuern.

## Revendications

1. Procédé de codage d'une position absolue utilisant un signal de position à n-bits prévu le long d'une première piste (1b) d'une plaque de codage (1) et utilisant un signal incrémental (2) ayant des transitions correspondant au pas dudit signal de position à n-bits (3) et prévu le long d'une seconde piste de ladite plaque de codage, ledit procédé de codage de position absolue comprenant les étapes de prévoir sur ladite plaque de codage une troisième piste contenant un signal (52) de m-bits, où ledit signal de m-bits est représentatif des positions de pole magnétique de l'élément tournant d'un servomoteur à courant alternatif ; lire ledit signal de m-bits au moment de la mise EN SERVICE et charger ledit signal de m-bits dans un circuit de comptage ; subséquemment lire ledit signal de position de n-bits de ladite plaque de codage et charger ledit signal de position lu de n-bits dans ledit circuit de comptage (12) ; et incrémenter ou décrémenter ledit signal de position chargé de n-bit selon des signaux lus de ladite piste incrémentale pour fournir la position angulaire codée dudit élément tournant dudit servomoteur.

2. Procédé de codage de position absolue selon la revendication 1, comprenant en outre les étapes d'utiliser un circuit de verrouillage (10) pour lire le signal de position (3) de n-bits précité aux instants où le signal incrémental précité change sa valeur ; et de charger ledit signal de position lu de n-bits par un convertisseur de signaux sérieparallèle (13) dans le circuit de comptage précité (12).

3. Procédé de codage de position absolue selon la revendication 1 ou la revendication 2, dans lequel le circuit de comptage précité (12) est amené à compter de façon ascendante en réponse aux signaux incrémentaux précités pour une première direction de rotation du servomoteur précité et à compter de façon descendante en réponse auxdits signaux incrémentaux pour une seconde direction de rotation dudit servomoteur.

4. Codeur de position absolue pour fournir un signal absolu (12A) en utilisant un signal de position (3) de n-bits formé sur une piste (1b) d'une plaque de codage (1), un signal incrémental (2) ayant des transitions correspondant au pas dudit signal de position de n-bits et formé sur une autre piste de ladite plaque de codage, et un signal de m-bits représentatif des positions de pôle magnétique d'un élément tournant d'un servomoteur à courant alternatif formé sur une autre piste de ladite plaque de codage, ledit codeur comprenant un circuit (11) vers le haut/vers le bas ayant une entrée couplée à un moyen pour lire ledit signal incrémental (2), un circuit de comptage (12) ayant une entrée couplée à une sortie dudit circuit (11) vers le haut/vers le bas, un circuit de verrouillage (10) ayant des entrées couplées au moyen pour lire ledit signal (3) de position de n-bits et ledit signal incrémental (2), un convertisseur de signaux série-parallèle ayant une entrée couplée à une sortie dudit circuit de verrouillage, un convertisseur de signaux binaires purs (100) et un sélecteur de données (50) couplés entre une sortie dudit convertisseur de signaux série-parallèle et un moyen d'entrée audit circuit de comptage, et un circuit de commande de charge, interconnectant ledit convertisseur des signaux binaires purs et une source d'un signal d'alimentation de MISE EN SERVICE/HORS SERVICE auxdits sélecteur de données et circuit de comptage, pour contrôler la charge dudit signal (52) de m-bits dans le circuit de comptage (12) au moment de mettre l'alimentation EN SERVICE.
